# EUROPÄISCHE PATENTSCHRIFT

(11) **EP 0 527 247 B1**
(45) Veröffentlichungstag und Bekanntmachung des Hinweises auf die Patenterteilung: **02.02.2000**
(21) Anmeldenummer: 91113357.7
(22) Anmeldetag: 08.08.1991
(51) Int. Cl.: H05K 7/14

(54) **Selbstaufbauender Bus**
Automatically built bus
Bus se construisant automatiquement

(43) Veröffentlichungstag der Anmeldung: 17.02.1993
(73) Patentinhaber: SIEMENS AKTIENGESELLSCHAFT, 80333 München (DE)
(72) Erfinder: Deinhardt, Günther, Dipl.-Ing. (FH), W-8450 Amberg (DE); Schirbl, Reinhard, W-8460 Schwandorf (DE)

(56) Entgegenhaltungen:
- EP-A- 0 236 711
- EP-A- 0 364 618
- US-A- 4 477 862
- US-A- 4 790 762

## Beschreibung

Die Erfindung betrifft einen selbstaufbauenden Bus für ein aus mehreren Baugruppen bestehendes, modulares Automatisierungsgerät gemäß dem Oberbegriff des Anspruchs 1. Darüber hinaus betrifft die Erfindung eine Baugruppe, die für einen Einsatz in einem derartigen Bus geeignet ist.

Aus der US-PS 4 477 862 ist eine Anlage bekannt, bei welcher die Rückwandbusmodule in einem modularen Baugruppenträger integriert sind, so daß die Baugruppenträger einzeln, z. B. an einer Wand, montiert werden müssen. Weiterhin ist es nicht möglich, einzelne Module des Rückwandbusses beliebig aus dem zusammengebauten Rückwandbus zu entfernen. Darüber hinaus ist die Baugruppenbreite durch die Breite der Baugruppenträger festgelegt.

Ein selbstaufbauender Bus gemäß dem Oberbegriff des Anspruchs 1 ist aus der EP 0 272 189 A2 bekannt. Eine Baugruppe weist in einer Aussparung auf der Rückseite ein Kontaktierungsteil auf und zur Herstellung einer elektrischen Verbindung mit einer weiteren Baugruppe wird ein Verbindungs-Modulteil nach dem Einrasten der Baugruppe zunächst bis zur Hälfte in die Aussparung dieser Baugruppe geschoben. Anschließend wird die weitere Baugruppe über die andere Hälfte des Verbindungs-Modulteils geschoben, wobei Kontaktsfedern auf der Oberseite des Verbindungs-Modulteils mit dem Kontaktierungsteil der jeweiligen Baugruppe die elektrische Verbindung bewirken.

Aus der DE-U-8 804 649.4 ist ein elektrisches Gerät bekannt, welches auf eine Tragschiene aufrastbar und welches mit Anschlüssen versehen ist, die zum elektrischen Verbinden mit einem weiteren elektrischen Gerät vorgesehen sind. Die Anschlüsse sind in Ausnehmungen der Stirn- und Seitenwände angeordnet, wobei mit U-förmigen Verbindungssteckern die Anschlüsse eines elektrischen Gerätes mit den Anschlüssen eines benachbarten elektrischen Gerätes verbindbar sind.

Der Erfindung liegt die Aufgabe zugrunde, einen selbstaufbauenden Bus der eingangs genannten Art zu schaffen, bei welchem der Grundaufwand für die Busverbindung möglichst gering gehalten wird. Weiterhin soll ein nachträgliches Ergänzen des Automatisierungsgerätes mit zusätzlichen Baugruppen möglich sein.

Diese Aufgabe wird durch die im kennzeichnenden Teil des Anspruchs 1 angegebenen Maßnahmen gelöst. Im Hinblick auf eine Baugruppe, die für einen Einsatz in einem derartigen Bus geeignet ist, weist die Baugruppe die im Anspruch 4 angegebenen Maßnahmen auf.

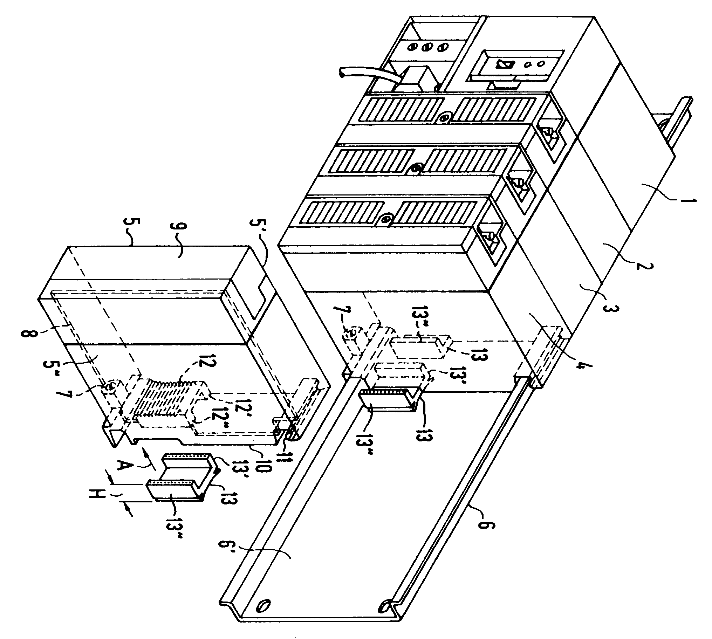

Weitere Vorteile und Einzelheiten ergeben sich aus der nachfolgenden Beschreibung eines Ausführungsbeispiels, anhand der Zeichnung und in Verbindung mit den weiteren Unteransprüchen.

Die Figur zeigt ein modulares Automatisierungsgerät mit an den Baugruppen angeordneten Busmodulen.

Gemäß der Figur sind die Zentraleinheit 1 sowie die Peripheriebaugruppen 2 bis 4 eines modularen Automatisierungsgeräts nebeneinander auf einen Träger 6, hier eine Hutschiene, aufgeschwenkt und nach den Aufschwenken mittels der Schraubverbindungen 7 gesichert. Die Baugruppen sind dabei zum Schutz vor Beschädigung der in den Baugruppen 2 bis 5 enthaltenen Leiterplatten 8 als umhüllende Gehäusekapsel ausgebildet. Durch die Kapselung wird gleichzeitig auch die Baugruppenbreite exakt definiert. Wie aus der FIG deutlich ersichtlich ist, ist dabei die Baubreite der Zentraleinheit 1 erheblich größer als die der Peripheriebaugruppen 2 bis 5.

Wie aus der FIG weiterhin ersichtlich ist, weisen die Baugruppen 1 bis 5 eine Bedienseite 9 zum Anschluß von externer Verdrahtung sowie gegenüber der Bedienseite 9 eine Rückwand 10 auf, wobei die Rückwand 10 nach dem Aufschwenken in Richtung der Hutschiene 6 zeigt, vorzugsweise an dieser anliegt. Am oberen Ende der Rückwand 10 ist eine Hakvorrichtung 11 angeordnet, an der die Baugruppen 1 bis 5 zum Aufschwenken an der Hutschiene 6 eingehängt werden. Weiterhin wird an der Rückwand 10 die Bus-Verbindung der Baugruppen 1 bis 5 aufgebaut. Hierzu sind an dem der Hakvorrichtung 11 gegenüberliegenden Ende der Rückwand 10 Busmodule angeordnet, die jeweils aus einem Baugruppen-Modulteil 12 und einem Verbindungs-Modulteil 13 bestehen.

Die Baugruppen-Modulteile 12 sind in den Baugruppen 1 bis 5 fest gelagert, und zwar derart, daß sie sich in den Baugruppen 1 bis 5 abstützen. Dadurch werden die beim Zusammenbau auftretenden mechanischen Beanspruchen von den in den Baugruppen 1 bis 5 enthaltenen Leiterplatten 8 ferngehalten. Selbstverständlich sind die Baugruppen-Modulteile 12 mit den Leiterplatten 8 aber elektrisch leitend verbunden. Die Verbindungs-Modulteile 13 sind den Baugruppen 1 bis 5 entfernbar, vorzugsweise steckbar zu geordnet. Das Einstecken erfolgt dabei, wie für die Baugruppe 5 durch den Pfeil A angedeutet, mittels einer im wesentlichen linearen Bewegung.

Sowohl das Baugruppen-Modulteil 12 als auch das Verbindungs-Modulteil 13 sind im wesentlichen U-förmig ausgestaltet und sowohl elektrisch als auch mechanisch Symmetrisch aufgebaut. Damit kann das Verbindungs-Modulteil 13 mit jedem seiner Schenkel 13', 13'' in jede der Schenkelaufnahmen 12', 12'' eingesetzt werden. Bei jeder dieser Verbindungsmöglichkeiten entsteht eine korrekte Busverbindung.

Das Baugruppen-Modulteil 12 ist derart ausgestaltet, daß die Schenkelaufnahmen 12', 12'' unabhängig von der Breite der Baugruppen, z.B. der Baugruppe 5, stets den gleichen Abstand zur nächstliegenden Seitenwand, z.B. den Seitenwänden 5', 5'' der Baugruppe 5, aufweisen. Das Verbindungs-Modulteil 13 ist derart ausgestaltet, daß es genau den Abstand zwischen zwei Schenkelaufnahmen 12', 12'' zweier benachbarter Baugruppen überbrückt. Die Schenkel 13', 13'' weisen hierzu einen Abstand auf, der gleich dem Doppelten des Abstands der Schenkelaufnahmen 12', 12'' von den Seitenwänden der Baugruppen, z.B. den Seitenwänden 51, 5'', ist. Die Busverbindung wird also dadurch aufgebaut, daß abwechselnd je ein Baugruppen-Modulteil 12 und ein Verbindungs-Modulteil 13 elektrisch und mechanisch miteinander verbunden sind.

Vorzugsweise ist die Bauhöhe H des Verbindungs-Modulteils 13 derart, daß es sich in zusammengebautem Zustand des Automatisierungsgerät an der Vorderseite 6' der Hutschiene 6 abstützt. Dadurch werden die mechanischen Beanspruchungen des Verbindungs-Modulteils 13 z.B. beim Aufschwenken der Baugruppe Verringert.

Vorzugsweise erfolgt der Zusammenbau des Automatisierungsgeräts derart, daß in die Baugruppen 1 bis 5 jeweils in die rechte Schenkelaufnahme 12'' der linke Schenkel 13' der zugeordneten Verbindungs-Modulteile 13 eingesetzt wird, so daß der rechte Schenkel 13'' rechts hinten aus den Baugruppen 1 bis 5 hervorragt, wie dies für die Baugruppe 4 angedeutet ist. Danach werden die Baugruppen 1, 2, 3, 4 und 5 nacheinander nebeneinander auf die Hutschiene 6 aufgeschwenkt. Durch das Aufschwenken wird dabei zwangsweise die elektrisch leitende Verbindung benachbarter Baugruppen untereinander hergestellt.

Mit der obenstehend beschriebenen Erfindung ist erstmals ein Aufbausystem geschaffen worden, daß seinen Rückwandbus selbsttätig aufbaut, also ohne einen an einem Baugruppenträger vormontierten Rückwandbus auskommt. Ferner können, wie obenstehend ausgeführt, Baugruppen beliebiger Baubreite aneinander angereiht werden, die Flexibilität des Automatisierungsgeräts wird also erhöht. Auch ist ein Ersetzen zentral gelegener Baugruppen, also von Baugruppen die links und rechts von anderen Baugruppen flankiert sind, ohne Demontage des gesamten Automatisierungsgeräts möglich. Weiterhin kann ein einzelnes Verbindungs-Modulteil 13 ebenso ohne Demontage des gesamten Automatisierungsgeräts durch Entfernen der beiden Baugruppen, in die es eingebunden ist, ersetzt werden. Die Anzahl der Baugruppen ist nur durch die Länge der Hutschiene 6 und die aufgrund der Übergangswiderstände an den Modulgrenzen entstehenden Spannungsabfälle begrenzt.

## Patentansprüche

1. Selbstaufbauender Bus, umfassend ein aus mehreren Baugruppen (1, 2, 3, 4, 5) bestehendes, modulares Automatisierungsgerät mit
- einer Gehäusekapsel für jede Baugruppe (1, 2, 3, 4, 5), die wenigstens eine Rückwand (10) und zwei Seitenwände (5', 5'') aufweist,
- einem an der Rückwand (10) jeder Baugruppe (1, 2, 3, 4, 5) angeordenten Kontaktierungsteil (12), das mit einem Verbindungs-Modulteils (13) elektrisch verbindbar zusammenwirkt, wodurch bei zusammengebautem Automatisierungsgerät benachbarte Baugruppen (1, 2, 3, 4, 5) zwangsweise abwechselnd je über ein Kontaktierungsteil und ein Verbindungs-Modulteil (13) elektrisch miteinander verbunden sind,
**dadurch gekennzeichnet**, daß
- das Kontaktierungsteil ein Baugruppen-Modulteil (12) mit, mehreren Buskontakten ist und mit einer Leiterplatte (8) der Baugruppe (1, 2, 3, 4, 5) elektrisch verbunden ist;
- das Baugruppen-Modulteil (12) in wesentlichen U-förmig ist und zwei Schenkel (12', 12'') aufweist, und sich die beiden Schenkel (12', 12'') im wesentlichen senkrecht zur Rückwand (10) in Richtung auf einen Träger (6) hin erstrecken;
- die Schenkel (12', 12'') des Baugruppen-Modulteils (12) stets den gleichen Abstand von der nächstliegenden Seitenwand (5' oder 5'') einer Baugruppe (1, 2, 3, 4, 5) aufweisen;
- die Basis und die Schenkel (13', 13'') des zum Baugruppen-Modulteil (12), komplementären, ebenfalls im wesentlichen U-förmigen Verbindungs-Modulteils (13) den Abstand zwischen zwei benachbarten Schenkeln (12', 12'') der Baugruppen-Modulteile (12) zweier benachbarter Baugruppen (1, 2, 3, 4, 5) bei zusammengebautem Automatisierungsgerät überbrücken;
- jede Baugruppe (1, 2, 3, 4, 5) an einer ersten Kante der Rückwand (10) eine Hakvorrichtung (11) aufweist, mittels der die Baugruppe (1, 2, 3, 4, 5) auf den Träger (6) aufschwenkbar ist, und an der der ersten Kante gegenüberliegenden Kante der Rückwand (10) das Baugruppen-Modulteil (12) angeordnet ist, wobei durch das Aufschwenken der Baugruppe (1, 2, 3, 4, 5) die Schenkel (13', 13'') des Verbindungs-Modulteils (13) in die Schenkel (12', 12'') des Baugruppen-Modulteils (12) mechanisch eingreifen.

2. Selbstaufbauender Bus nach Anspruch 1, **dadurch gekennzeichnet**, daß das Baugruppen-Modulteil (12) in der Baugruppe fest gelagert ist, derart, daß sich das Baugruppen-Modulteil (12) in der Baugruppe abstützt.

3. Selbstaufbauender Bus nach Anspruch 1 oder 2, **dadurch gekennzeichnet**, daß die Baugruppe nach dem Aufschwenken auf den Träger (6) sicherbar ist.

4. Baugruppe für ein aus mehreren Baugruppen (1, 2, 3, 4, 5) bestehendes, modulares Automatisierungsgerät mit
- einer Gehäusekapsel, die wenigstens eine Rückwand (10) und zwei Seitenwände (5', 5'') aufweist,
- einem an der Rückwand (10) der Baugruppe angeordneten Kontaktierungsteil (12) das mit einem Verbindungs-Modulteil (13) elektrisch verbindbar zusammenwirkt, wodurch bei zusammengebautem Automatisierungsgerät benachbarte Baugruppen (1, 2, 3, 4, 5) zwangsweise abwechselnd je über ein Kontaktierungsteil (12) und ein Verbindungs-Modulteil (13) elektrisch miteinander verbunden sind,
**dadurch gekennzeichnet**, daß
- das Kontaktierungsteil ein Baugruppen-Modulteil (12) mit mehreren Buskontakten ist
- und mit einer Leiterplatte (8) der Baugruppe (1, 2, 3, 4, 5) elektrisch verbunden ist;
- das Baugruppen-Modulteil (12) im wesentlichen U-förmig ist und zwei Schenkel (12', 12'') aufweist, und sich die beiden Schenkel (12', 12'') im wesentlichen senkrecht zur Rückwand (10) in Richtung auf einen Träger (6) hin erstrecken;
- die Schenkel (12', 12'') des Baugruppen-Modulteils (12) stets den gleichen Abstand von der nächstliegenden Seitenwand (5' oder 5'') aufweisen;
- die Basis und die Schenkel (13', 13'') des zum Baugruppen-Modulteil (12), komplementären, ebenfalls im wesentlichen U-förmigen Verbindungs-Modulteils (13) den Abstand zwischen einem Schenkel (12', 12'') des Baugruppen-Modulteils (12) von einem benachbarten Schenkel (12', 12'') eines Baugruppen-Modulteils (12) einer benachbarten Baugruppe (1, 2, 3, 4, 5) bei zusammengebautem Automatisierungsgerät überbrücken;
- die Baugruppe (1, 2, 3, 4, 5) an einer ersten Kante der Rückwand (10) eine Hakvorrichtung (11) aufweist, mittels der die Baugruppe (1, 2, 3, 4, 5) auf den Träger (6) aufschwenkbar ist, und an der der ersten Kante gegenüberliegenden Kante der Rückwand (10) das Baugruppen-Modulteil angeordnet ist, wobei durch das Aufschwenken der Baugruppe (1, 2, 3, 4, 5) die Schenkel (13', 13'') des Verbindungs-Modulteils (13) in die Schenkel (12', 12'') des Baugruppen-Modulteils (12) mechanisch eingreifen.

5. Baugruppe nach Anspruch 4, **dadurch gekennzeichnet**, daß das Baugruppen-Modulteil (12) in der Baugruppe fest gelagert ist, derart, daß sich das Baugruppen-Modulteil (12) in dar Baugruppe abstützt.

6. Baugruppe nach Anspruch 4 oder 5, **dadurch gekennzeichnet**, daß die Baugruppe nach dem Aufschwenken auf den Träger (6) sicherbar ist.

## Claims

1. Self-constructing bus, comprising a modular programmable controller consisting of a plurality of subassemblies (1, 2, 3, 4, 5), having
- a housing enclosure for each subassembly (1, 2, 3, 4, 5) which has at least one back panel (10) and two side walls (5', 5''),
- a contacting portion (12) arranged on the back panel (10) of each subassembly (1, 2, 3, 4, 5) that cooperates in an electrically connectable manner with a connecting module portion (13), as a result of which in the case of an assembled programmable controller, adjacent subassemblies (1, 2, 3, 4, 5) are inevitably electrically connected to each other in an alternating manner by way of a respective contacting portion (12) and a connecting module portion (13),
characterised in that
- the contacting portion is a subassembly-module portion (12) having a plurality of bus contacts and is electrically connected to a printed-circuit board (8) of the subassembly (1, 2, 3, 4, 5);
- the subassembly-module portion (12) is substantially U-shaped and has two limbs (12', 12''), and the two limbs (12', 12'') extend substantially at right angles to the back panel (10) in the direction of a support (6);
- the limbs (12', 12'') of the subassembly-module portion (12) always have the same distance from the closest side wall (5' or 5'');
- the base and the limbs (13', 13'') of the substantially U-shaped connecting module portion (13) which is complementary to the subassembly-module portion (12) bridge the distance between a limb (12', 12'') of the subassembly-module portion (12) and an adjacent limb (12', 12'') of a subassembly-module portion (12) of an adjacent subassembly (1, 2, 3, 4, 5) in the case of an assembled programmable controller;
- each subassembly (1, 2, 3, 4, 5) has, on a first edge of the back panel (10), a hook device (11), by means of which the subassembly (1, 2, 3, 4, 5) can be swung round on to the support (6), and arranged on the edge of the back panel (10) that is opposite the first edge is the subassembly-module portion, wherein, as a result of the swinging-round of the subassembly (1, 2, 3, 4, 5), the limbs (13', 13'') of the connecting module portion (13) engage mechanically in the limbs (12', 12'') of the subassembly-module portion (12).

2. Self-constructing bus according to claim 1, characterised in that the subassembly-module portion (12) is securely mounted in the subassembly, in such a way that the subassembly-module portion (12) is supported in the subassembly.

3. Self-constructing bus according to claim 1 or 2, characterised in that the subassembly can be secured after the swinging-round on to the support (6).

4. Subassembly for a modular programmable controller consisting of a plurality of subassemblies (1, 2, 3, 4, 5), having
- a housing enclosure which has at least one back panel (10) and two side walls (5', 5'');
- a contacting portion (12) arranged on the back panel (10) of the subassembly that cooperates in an electrically connectable manner with a connecting module portion (13), as a result of which in the case of an assembled programmable controller, adjacent subassemblies (1, 2, 3, 4, 5) are inevitably electrically connected to each other in an alternating manner by way of a respective contacting portion (12) and a connecting module portion (13),
characterised in that
- the contacting portion is a subassembly-module portion (12) having a plurality of bus contacts and is electrically connected to a printed-circuit board (8) of the subassembly (1, 2, 3, 4, 5);
- the subassembly-module portion (12) is substantially U-shaped and has two limbs (12', 12''), and the two limbs (12', 12'') extend substantially at right angles to the back panel (10) in the direction of a support (6),
- the limbs (12', 12'') of the subassembly-module portion (12) always have the same distance from the closest side wall (5' or 5''),
- the base and the limbs (13', 13'') of the substantially U-shaped connecting module portion (13) which is complementary to the subassembly-module portion (12) bridge the distance between a limb (12', 12'') of the subassembly-module portion (12) and an adjacent limb (12', 12'') of a subassembly-module portion (12) of an adjacent subassembly (1, 2, 3, 4, 5) in the case of an assembled programmable controller;
- each subassembly (1, 2, 3, 4, 5) has, on a first edge of the back panel (10), a hook device (11), by means of which the subassembly (1, 2, 3, 4, 5) can be swung round on to the support (6), and arranged on the edge of the back panel (10) that is opposite the first edge is the subassembly-module portion, wherein, as a result of the swinging-round of the subassembly (1, 2, 3, 4, 5), the limbs (13', 13'') of the connecting module portion (13) engage mechanically in the limbs (12', 12'') of the subassembly-module portion (12).

5. Subassembly according to claim 4, characterised in that the subassembly-module portion (12) is securely mounted in the subassembly, in such a way that the subassembly-module portion (12) is supported in the subassembly.

6. Subassembly according to claim 4 or 5, characterised in that the subassembly can be secured after the swinging-round on to the support (6).

## Revendications

1. Bus se construisant automatiquement, comprenant un appareil d'automatisation modulaire, constitué de plusieurs modules (1, 2, 3, 4, 5), comportant
- une capsule de boîtier pour chaque module (1, 2, 3, 4, 5), qui comporte au moins un panneau (10) arrière et deux panneaux (5', 5'') latéraux,
- une pièce (12) de mise en contact, qui est montée sur le panneau (10) arrière de chaque module (1, 2, 3, 4, 5) et qui coopère avec une pièce (13) modulaire de liaison de manière à pouvoir être reliée électriquement, ce qui fait que, lorsque l'appareil d'automatisation est assemblé, des modules (1, 2, 3, 4, 5) voisins sont reliés les uns aux autres de manière conductrice de l'électricité nécessairement alternativement chaque fois par l'intermédiaire d'une pièce (12) de mise en contact et d'une pièce (13) modulaire de liaison,
caractérisé en ce que
- la pièce de mise en contact est une pièce (12) modulaire pour module comportant plusieurs contacts de bus et est reliée de manière conductrice de l'électricité à une plaquette (8) à circuit imprimé du module (1, 2, 3, 4, 5);
- la pièce (12) modulaire pour module est sensiblement en forme de U et comporte deux branches (12', 12''), et les deux branches (12', 12'') s'étendent sensiblement perpendiculairement au panneau (10) arrière en direction d'un support (6);
- les branches (12', 12'') de la pièce (12) modulaire pour module sont toujours à la même distance du panneau (5' ou 5'') latéral le plus proche;
- la base et les branches (13', 13'') de la pièce (13) modulaire de liaison qui est complémentaire de la pièce (12) modulaire pour module et qui est également sensiblement en forme de U comble la distance entre une branche (12', 12'') de la pièce (12) modulaire pour module et une branche (12', 12'') voisine d'une pièce (12) modulaire pour module d'un module (1, 2, 3, 4, 5) voisin lorsque l'appareil d'automatisation est assemblé;
- chaque module (1, 2, 3, 4, 5) comporte sur un premier bord du panneau (10) arrière un dispositif (11) à crochet, au moyen duquel le module (1, 2, 3, 4, 5) peut être basculé sur le support (6), la pièce modulaire de module est montée sur le bord du panneau (10) arrière faisant face au premier bord, les branches (13', 13'') de la pièce (13) modulaire de liaison pénétrant mécaniquement dans les branches (12', 12'') de la pièce (12) modulaire pour module par le basculement du module (1, 2, 3, 4, 5).

2. Bus se construisant automatiquement suivant la revendication 1, caractérisé en ce que la pièce (12) modulaire pour module est montée à poste fixe dans le module de telle manière que la pièce (12) modulaire pour module prend appui dans le module.

3. Bus se construisant automatiquement suivant la revendication 1 ou 2, caractérisé en ce que le module peut être bloqué après le basculement sur le support (6).

4. Module pour un appareil d'automatisation modulaire constitué de plusieurs modules .(1, 2, 3, 4, 5), comportant
- une capsule de boîtier qui comporte au moins un panneau (10) arrière et deux panneaux (5', 5'') latéraux,
- une pièce (12) de mise en contact qui est montée sur le panneau (10) arrière du module et qui coopère avec une pièce (13) modulaire de liaison de manière à pouvoir à être reliée électriquement, ce qui fait que, lorsque l'appareil d'automatisation est assemblé, des modules (1, 2, 3, 4, 5) voisins sont reliés les uns aux autres de manière conductrice de l'électricité nécessairement alternativement chaque fois par l'intermédiaire d'une pièce (12) de mise en contact et d'une pièce (13) modulaire de liaison,
caractérisé en ce que
- la pièce de mise en contact est une pièce (12) modulaire pour module comportant plusieurs contacts de bus et est reliée de manière conductrice de l'électricité à une plaquette (8) à circuit imprimé du module (1, 2, 3, 4, 5);
- la pièce (12) modulaire pour module est sensiblement en forme de U et comporte deux branches (12', 12''), et les deux branches (12', 12'') s'étendent sensiblement perpendiculairement au panneau (10) arrière en direction d'un support (6);
- les branches (12', 12'') de la pièce (12) modulaire pour module ont toujours la même distance au panneau (5' ou 5'') latéral le plus proche;
- la base et les branches (13', 13'') de la pièce (13) modulaire de liaison qui est complémentaire de la pièce (12) modulaire pour module et qui est également sensiblement en forme de U comble la distance entre une branche (12', 12'') de la pièce (12) modulaire pour module à une branche (12', 12'') voisine d'une pièce (12) modulaire pour module d'un groupe (1, 2, 3, 4, 5) voisin lorsque l'appareil d'automatisation est assemblé;
- le module (1, 2, 3, 4, 5) comporte sur un premier bord du panneau (10) arrière un dispositif (11) à crochet, au moyen duquel le module (1, 2, 3, 4, 5) peut être basculé sur le support (6), et la pièce modulaire pour module est montée sur le bord du panneau (10) arrière faisant face au premier bord, les branches (13', 13'') de la pièce (13) modulaire de liaison pénétrant mécaniquement dans les branches (12', 12'') de la pièce (12) modulaire pour module par le basculement du module (1, 2, 3, 4, 5).

5. Module suivant la revendication 4, caractérisé en ce la pièce (12) modulaire pour module est montée à poste fixe dans le module, de telle manière que la pièce (12) modulaire pour module prend appui dans le module.

6. Module suivant la revendication 4 ou 5, caractérisé en ce que le module peut être bloqué après le basculement sur le support (6).
